# EUROPEAN PATENT SPECIFICATION

(11) **EP 0 704 730 B1**
(45) Date of publication and mention of the grant of the patent: **29.12.1999**
(21) Application number: 95115358.4
(22) Date of filing: 28.09.1995
(51) Int. Cl.: G02B 6/42, H01S 3/025

(54) **Transmitter module for optical interconnections**
Sendemodul für optische Verbindungen
Module de transmission pour interconnexion optique

(30) Priority: 29.09.1994 IT TP940757
(43) Date of publication of application: 03.04.1996
(73) Proprietor: CSELT Centro Studi e Laboratori Telecomunicazioni S.p.A., 10148 Turin (IT)
(72) Inventor: Bostica, Bruno, I-10025 Pino Torinese (TO) (IT); Delpiano, Franco, I-10093 Collegno (TO) (IT); Pesando, Luca, I-10053 Bussoleno (TO) (IT)
(74) Representative: Riederer Freiherr von Paar zu Schönau, Anton

(56) References cited:
- EP-A- 0 243 057
- WO-A-84/01057
- DE-U- 8 234 091
- FR-A- 2 503 458
- GB-A- 2 230 647
- US-A- 4 802 178
- PATENT ABSTRACTS OF JAPAN vol. 005 no. 153 (E-076) ,26 September 1981 & JP-A-56 085882 (NEC CORP) 13 July 1981,

## Description

The invention described herein relates to optical fibre telecommunication systems and in particular to a transmitter module for optical interconnections.

It is well known that the "optical" approach to the problem of interconnecting different elements of telecommunication systems or, more in general, of data transmission systems, provides a solution to rate, cross-talk and impedance mismatching problems, which constitute the limitation of the interconnection techniques that use electrical supports.

The elements required to build an optical interconnection are the transmitter, the receiver and the transmission medium connecting them. Inside the transmitter there is the source of light radiation, made by a solid state device (a laser or a LED), which is associated with an electronic circuit arranged to control its operation. Transmission of the light emitted by the optical source is, in most cases, entrusted to an optical fibre, which must be accurately coupled with the emitting device in order to maximise the radiation collection efficiency.

Perfect coupling must be maintained throughout the operating time of the interconnection and therefore it must be accomplished with a technique that will guarantee its stability in the presence of thermal or mechanical disturbances. For this reason it is common practice to equip the transmitter with a length of optical fibre, called pig tail, firmly secured so as to guarantee coupling optimisation and stability. The end of the pig tail is secured with the most suitable technique to the actual transport fibre.

Problems of impedance mismatching and of parasite couplings also affect the electrical connections inside the transmitter, between the driving circuit and the optical emitting device. These problems add to those of size, which must be kept down to minimal values, and of dissipation of the power generated by the emitting device and by the driving circuit, which dissipation must be adequately controlled in order to guarantee the operating stability of the transmitter as a whole.

A known method of assembling the driving circuit and the laser (or LED) inside a transmission module is described in the article "IBM Enterprise Systems multimode fibre optic technology", by N.R. Aulet et al, IBM J. Res. Develop. Vol. 36, no. 4, pages 553-575, 4 July 1992. According to this method, the integrated circuit driving the laser and the laser itself are housed on a common support, which may be a wafer, for instance made of ceramic material or silicon, and are connected to each other by means of a wire bonded at their ends on metal areas provided on the devices themselves for this purpose, according to the technique known as "wire bonding".

From WO 84/01057, an arrangement is known wherein on a printed circuit board, both an optical emitting device comprising a fibre pigtail, and an integrated circuit comprising a driving circuit are mounted, which components are electrically connected by conductor tracks and a wire lead.

These solutions do not allow reducing the distances of the connections below a certain measure and require a total mounting area that is substantially larger than the area of just the integrated circuit containing the laser driving circuit. Moreover, aligning the emitting device with the optical fibre requires additional space for assembly operations, which are complex and laborious.

These drawbacks are obviated by the transmitter module for optical interconnections according to the present invention, which uses a type of assembly by means of which the problems due to the length of the bonding wires through several connection sections realized with different techniques are minimised, and in which assembly times, parasite effects and signal reflection effects caused by impedance mismatching are reduced. The module requires reduced power for its operation and it is provided with a structure facilitating dissipation.

More particularly, the present invention provides a transmitter module for optical interconnections, comprising a metallic container housing an optical emitting device, an integrated circuit containing a driving circuit for the optical emitting device and an optical fibre facing the light-emitting surface of optical emitting device and outgoing from the container through a fibre guiding device, said optical emitting device having an anode electrically connected to a first metallic area connected with the output of the driving circuit within the integrated circuit, and a cathode electrically connected to a second metallic area, characterised in that the metallic areas are formed on said integrated circuit and said optical emitting device is secured through its cathode to the second metallic area, which is a ground area, and in that said optical fibre is secured onto said integrated circuit.

These and other characteristics of the present invention shall be clarified better by the following description of a preferred embodiment of the same, given by way of non-limiting example, and by the enclosed drawings in which:
- Figure 1 is a plan view of the module;
- Figure 2 is a longitudinal sectional view of the module.

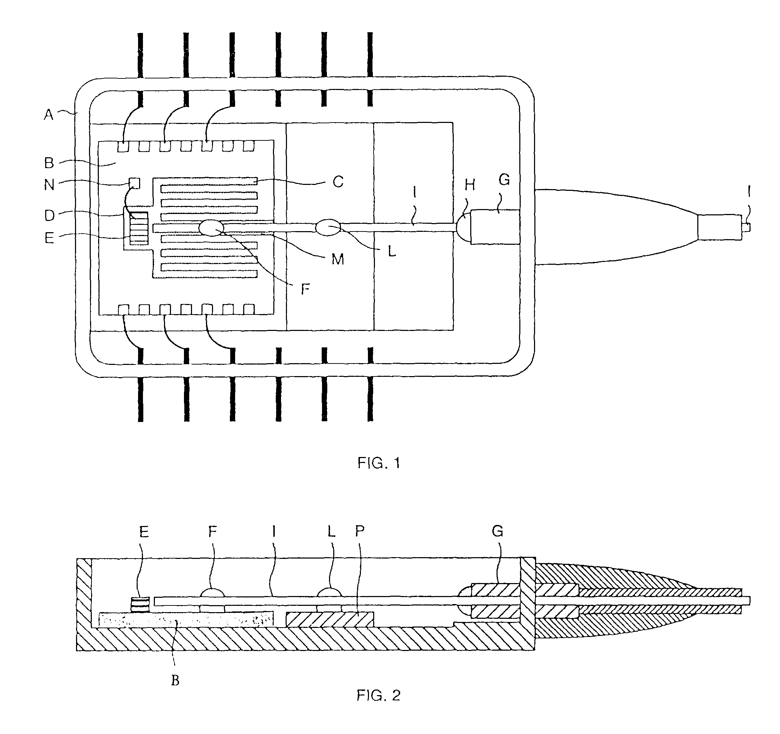

In Figure 1, "A" indicates a metal container, of the "flat pack" type, which is to contain and to afford mechanical protection to the assembly, as well as to act as an electromagnetic shield. An integrated circuit B containing the laser driving circuit is located inside the container. This integrated circuit is provided on its surface with a metal ground, i.e. connected to earth area D on which a laser diode E is mounted. This is secured to the ground area by means of an electrically conducting adhesive, for example silver-charged epoxy resin, so that the driving current can flow in the cathode. The ground area extends over the integrated circuit surface by means of metallization strips C, which act as thermal dissipation means for the laser.

The laser anode is connected by a bonding wire to a second metal area N, connected to the driving circuit within the integrated circuit.

The light-emitting surface of the laser is faced by an optical fibre I with pig tail functions. Fiber I can easily be positioned in correspondence of the light-emitting surface thanks also to the help of a central metallization strip M, deposited on the surface of the integrated circuit and acting as a visual guide for the alignment.

The fibre is secured to the integrated circuit at a point F, to the metal container at a point L and to a fibre guiding device G at a point H by epoxy resin gluing.

Since the laser is mounted directly on the surface of the integrated circuit containing the driving circuit, as previously described, the problems due to the length of the bonding wires and to the passage through different connection sections realized with different techniques are minimised. A single, very short bonding wire is required between the upper metallized surface of the laser and the metal area connected to the output of the driving circuit.

Such mounting requires in any case good power dissipation, lacking which the laser would undergo overheating, which would compromise its correct operation. This thermal dissipation is guaranteed by the aforesaid metallization strips.

Another important factor, from the point of view of thermal balance, is constituted by the CMOS technology in which the driving circuit is realized: as known, this technology is characterized by reduced power consumption.

Figure 2 highlights how the fibre is horizontally aligned to the emitting device thanks to a projecting portion P of the metal container, whose thickness is equal to that of the integrated circuit. Point L for securing the fibre, mentioned previously, is realized on this projecting portion.

The existence of a fibre securing point directly on the integrated circuit, near the laser diode, improves the efficiency and stability of the optical coupling in the presence of temperature variations and of mechanical stresses.

It is evident that what has been described is provided solely by way of non-limiting example. Variations and modifications are possible without departing from the scope of the invention as defined in the claims.

## Claims

1. Transmitter module for optical interconnections, comprising a metallic container (A) housing an optical emitting device (E), an integrated circuit (B) containing a driving circuit for the optical emitting device and an optical fibre (I) facing the light-emitting surface of the optical emitting device (E) and outgoing from the container through a fibre guiding device (G), said optical emitting device having an anode electrically connected to a first metallic area (N) connected with the output of the driving circuit within the integrated circuit, and a cathode electrically connected to a second metallic area (D), characterised in that the metallic areas (N, D) are formed on said integrated circuit (B) and said optical emitting device (E) is secured through its cathode to the second metallic area (D), which is a ground area, and in that said optical fibre (I) is secured onto said integrated circuit (B).

2. Transmitter module for optical interconnections as claimed in claim 1, characterized in that said second metallic ground area (D) extends over the surface of the integrated circuit by means of metallization strips (C), acting as thermal dissipation means for said optical emitting device (E).

3. Transmitter module for optical interconnections as claimed in claim 2, characterized in that a central metallization strip (M) is realized on the surface of the integrated circuit and acts as a visual guide for aligning said optical fibre (I) with the light-emitting surface of the optical emitting device (E).

4. Transmitter module for optical interconnections as claimed in any of claims 1 to 3, characterized in that said optical fibre (I) is furthermore secured to the metal container on a projecting portion (P) having a thickness equal to that of the integrated circuit (B), and to the fibre guiding device (G).

## Patentansprüche

1. Sendemodul für optische Verbindungen, umfassend einen metallenen Behälter (A), der ein lichtemittierendes Bauelement (E), eine integrierte Schaltung (B) mit einer Treiberschaltung für das lichtemittierende Bauelement und eine Lichtleitfaser (1), die der lichtemittierenden Fläche des lichtemittierenden Bauelements (E) gegenüberliegt und aus dem Behälter durch eine Faserführungsvorrichtung (G) austritt, gehäuseartig enthält, wobei das lichtemittierende Bauelement eine elektrisch mit einer ersten metallenen Fläche (N) verbundene Anode, die mit dem Ausgang der Treiberschaltung in der integrierten Schaltung verbunden ist, und eine elektrisch mit einer zweiten metallenen Fläche (D) verbundene Kathode aufweist, dadurch gekennzeichnet, daß die metallenen Flächen (N, D) auf der integrierten Schaltung (B) gebildet sind und das lichtemittierende Bauelement (E) durch seine Kathode an der zweiten metallenen Fläche (D), die eine geerdete Fläche ist, befestigt ist, und daß die Lichtleiffaser (I) auf der integrierten Schaltung (B) befestigt ist.

2. Sendemodul für optische Verbindungen nach Anspruch 1, dadurch gekennzeichnet, daß die zweite metallene geerdete Fläche (D) sich über die Fläche der integrierten Schaltung mit Hilfe von Metallisierungsstreifen (C) erstreckt, die als Einrichtung zur Wärmedissipation für das lichtemittierende Bauelement (E) wirken.

3. Sendemodul für optische Verbindungen nach Anspruch 2, dadurch gekennzeichnet, daß auf der Oberfläche der integrierten Schaltung ein zentraler Metallisierungsstreifen (M) gebildet ist, der als visuelle Führung zum Ausrichten der Lichtleiffaser (I) auf die lichtemittierende Fläche des lichtemittierenden Bauelements (E) dient.

4. Sendemodul für optische Verbindungen nach einem der Ansprüche 1 bis 3, dadurch gekennzeichnet, daß die Lichtleiffaser (I) weiterhin am Metallbehälter auf einem vorspringenden Teil (P), dessen Dicke gleich der der integrierten Schaltung (B) ist, sowie an der Faserführungsvorrichtung (G) befestigt ist.

## Revendications

1. Module de transmission pour interconnexions optiques, comprenant une boîte métallique (A) contenant un dispositif émetteur optique (E), un circuit intégré (B) contenant un circuit de pilotage pour le dispositif émetteur optique, et une fibre optique (I) placée en face de la surface d'émission de la lumière du dispositif émetteur optique (E) et sortant de la boîte à travers un dispositif (G) de guidage de la fibre, ledit dispositif émetteur optique comportant une anode connectée à une première aire métallique (N) connectée avec la sortie du circuit de pilotage dans le circuit intégré, et une cathode connectée électriquement à une seconde aire métallique (D), caractérisé en ce que les aires métalliques (N, D) sont formées sur ledit circuit intégré (B) et ledit dispositif émetteur optique (E) est fixé par sa cathode à la seconde aire métallique (D) qui est une aire de masse, et en ce que ladite fibre optique (I) est fixée sur ledit circuit intégré (B).

2. Module de transmission pour interconnexions optiques comme dans la revendication 1, caractérisé en ce que ladite seconde aire métallique de masse (D) s'étend sur la surface du circuit intégré grâce à des bandes de métallisation (C), qui agissent en moyen de dissipation thermique pour ledit dispositif émetteur optique (E).

3. Module de transmission pour interconnexions optiques comme dans la revendication 2, caractérisé en ce qu'une bande centrale de métallisation (M) est réalisée sur la surface du circuit intégré et agit en guide visuel pour l'alignement de ladite fibre optique (I) avec la surface d'émission de la lumière du dispositif émetteur optique (E).

4. Module de transmission pour interconnexions optiques comme dans l'une quelconque des revendications 1 à 3, caractérisé en ce que ladite fibre optique (I) est en outre fixée à la boîte métallique sur une partie saillante (P) ayant une épaisseur égale à celle du circuit intégré (B), et au dispositif (G) de guidage de la fibre.
